# EUROPÄISCHE PATENTSCHRIFT

(11) **EP 4 101 269 B1**
(45) Veröffentlichungstag und Bekanntmachung des Hinweises auf die Patenterteilung: **17.06.2026**
(21) Anmeldenummer: 21706033.4
(22) Anmeldetag: 04.02.2021
(51) Int. Cl.: H05K 1/02, H05K 1/14, H05K 1/11, H05K 3/30, H05K 3/34, H05K 3/10, H05K 3/00

(54) **BAUTEILTRÄGER ZUR ANORDNUNG ELEKTRISCHER BAUTEILE AUF EINER LEITERKARTE**
COMPONENT CARRIER FOR ARRANGEMENT OF ELECTRIC COMPONENTS ON A CIRCUIT BOARD
SUPPORT DE COMPOSANT POUR AGENCEMENT DE COMPOSANTS ÉLECTRIQUES SUR UN CIRCUIT IMPRIMÉ

(30) Priorität: 05.02.2020 DE 102020102983
(43) Veröffentlichungstag der Anmeldung: 14.12.2022
(73) Patentinhaber: Harting AG, 2500 Biel 6 (CH)
(72) Erfinder: HESS, Thomas, 2500 Biel 6 (CH)
(74) Vertreter: Ridderbusch, Oliver
(86) Internationale Anmeldenummer: PCT/IB2021/050923
(87) Internationale Veröffentlichungsnummer: WO 2021/156793

(56) Entgegenhaltungen:
- WO-A1-2013/189486
- US-A1- 2005 168 961

## Beschreibung

Die Erfindung geht aus von einem Bauteilträger zur Anordnung elektrischer Bauteile auf einer Leiterkarte nach der Gattung des unabhängigen Anspruchs 1.

Des Weiteren geht die Erfindung aus von einem Verfahren zur Bestückung einer Leiterkarte mit elektrischen Bauteilen mittels mindestens eines Bauteilträgers gemäß Anspruch 1.

Derartige Bauteilträger und Verfahren werden benötigt, um elektrische Bauteile auf Leiterkarten zu befestigen und sie elektrisch damit zu verbinden.

### Stand der Technik

Im Stand der Technik ist es bekannt, Leiterkarten automatisiert mit elektrischen Bauteilen zu bestücken. Insbesondere kann dies mittels der weit verbreiteten "surface mounted technologie" (SMT) geschehen.

Ein Hauptproblem bei der automatisierten Bestückung von Leiterkarten besteht darin, dass diese Bauteile oft individuelle Anschlüsse besitzen. Dies erschwert sowohl das Leiterkartenlayout als auch die Flexibilität der Bestückung bezüglich der späteren Auswahl geeigneter Bauteile. Insbesondere kann die Automatisierung der Bestückung der Leiterkarte mit alternativen Bauteilen, welche funktional und preislich durchaus attraktiv wären, behindert oder gar unmöglich werden.

Aufgrund ihrer Temperaturempfindlichkeit sind viele elektrische Bauteile nicht ohne weiteres zur SMT-Verlötung geeignet.

Weiterhin wird der geringe Bauraum auf Leiterkarten für nahezu sämtlichen Schaltungsdesigns als problematisch angesehen, d.h. es besteht grundsätzlich das Bedürfnis, den bestehenden Bauraum möglichst effektiv auszunutzen, um eine möglichst hohe Funktionalität auf möglichst geringem Platz zu ermöglichen. Dadurch kann auch im Betrieb die Temperaturentwicklung durch leistungsstarke Elektronikbauteile, z.B. Mikroprozessoren, oft problematisch werden, so dass der Einsatz von Kühlkörpern und/oder Lüftern nötig wird, was wiederum den Platzbedarf weiter steigert.

Aus der US 2005/0168961 A1 ist eine stereoskopische elektronische Schaltkreisvorrichtung mit einer darin verwendeten Relaisplatine und einem Relaisrahmen bekannt. Die Schaltkreisvorrichtung weist eine stereoskopisch verbundene Struktur auf und besteht aus einer ersten und zweiten Leiterkarte, die mit weiteren elektronischen Komponenten bestückt sind. Die Relaisplatine weist eine Aussparung auf, die mit einem elektronischen Bauteil bestückt ist und mit sich von dem elektronischen Bauteil erstreckenden, herausgeführten Leitungen versehen ist. Die Relaisplatine weist auf einer ihrer Oberflächen, die der ersten und zweiten Leiterkarte zugewandt ist, eine Anschlussfläche zur Verbindung mit den herausgeführten Leitungen auf. Somit kann die Relaisplatine das elektronische Bauteil tragen sowie die erste und zweite Leiterkarte verbinden, wodurch eine Anordnung mit hoher Dichte erreicht wird.

Aus der WO 2013/189486 A1 ist ein Verfahren zur Herstellung einer Leiterbahnstruktur auf einem dielektrischen Trägermaterial bekannt. Dabei wird das Trägermaterial zunächst mit einer flächigen Beschichtung versehen. In der Beschichtung sind nanoskalige Partikel enthalten, die als einen wesentlichen Materialanteil Metalloxide, beispielsweise Kupferoxide enthalten, die mit einem geeigneten Reduktionsmittel beschichtet sind. Anschließend wird die Beschichtung selektiv einer elektromagnetischen Strahlung eines Lasers ausgesetzt. Dadurch kommt es aufgrund der selektiven Strahlungseinwirkung zu einem Versintern von in der Beschichtung enthaltenen oder in situ erzeugten Partikeln, wobei sich die Leiterbahnstruktur ausbildet.

### Aufgabenstellung

Die Aufgabe der Erfindung besteht darin, die Automatisierung der Bestückung von Leiterkarten zu vereinfachen oder überhaupt erst zu ermöglichen. Insbesondere soll dabei die Flexibilität der Bauteilauswahl erhöht werden, sowie ein optimierter ansaugbarer Bauteilträger bereitgestellt werden.

Die Aufgabe wird durch den Gegenstand der unabhängigen Ansprüche gelöst.

Ein Bauteilträger besteht aus einem elektrisch isolierenden Material, insbesondere einem Kunststoff, und ist bevorzugt in einem sogenannten "MID" (moulded interconnect device)-Verfahren und insbesondere im sogenannten "LDS" (Laser Direct Structuring) - Verfahren gefertigt. Dazu kann der Bauteilträger aus einem oder mehreren MID-fähigen und insbesondere LDS-fähigen Kunststoff(en) bestehen oder diese(n) zumindest abschnittsweise aufweisen. Der Bauteilträger besitzt einen Basisbereich mit einer oder mehreren Auflageflächen zur elektrischen und mechanischen Verbindung mit einer Leiterkarte. Weiterhin besitzt der Bauteilträger einen im Wesentlichen rechtwinklig zu der/den Auflagefläche(n) des Basisbereichs verlaufenden, im Wesentlichen flächigen Verbindungsabschnitt, der zumindest eine ebene Seitenfläche besitzt, auf der ein- oder mehrere elektrische Bauteile montiert werden können. An einem vom Basisbereich abgewandten Ende des Verbindungsabschnitts besitzt der Bauteilträger eine parallel zum Basisbereich ausgerichtete Kopffläche. Diese Kopffläche ist sowohl als Ansaugfläche zur automatisierten Leiterkartenbestückung, beispielsweise im SMT-Verfahren, als auch zur Montage eines oder mehrerer weiterer elektrischer Bauteile nutzbar. Der Bauteilträger ist mit mehreren Leiterbahnen versehen, welche leiterkartenanschlussseitig an zumindest eine der Auflageflächen des Basisbereichs geführt sind und dort zur Verlötung mit der Leiterkarte mit ihren jeweiligen Leiterkartenanschlussbereichen enden. An ihrem jeweils anderen Ende sind die Leiterbahnen zur jeweiligen Montageposition eines der elektrischen Bauteile geführt und enden dort mit ihren Bauteilanschlussbereichen jeweils in der Nähe der elektrischen Anschlüsse des dort zu montierenden Bauteils.

Der Verbindungsabschnitt ist beidseitig flächig ausgebildet und besitzt somit zwei einander gegenüberliegende Montageflächen, wobei der flächige Bereich ausreichend groß zur Montage eines elektrischen Bauteils ist. An den Verbindungsabschnitt ist an einem dem Basisbereich abgewandten Ende parallel zum Basisbereich, insbesondere rechtwinklig dazu, eine Kopfplatte angeformt, welche an ihrer dem Basisbereich abgewandten Seite die Kopffläche aufweist. Die Kopfplatte ist an den Verbindungsabschnitt nur einseitig, also in Richtung einer ihrer beiden einander gegenüberliegenden Montageflächen, von dem Verbindungsabschnitt fortweisend angeformt, so dass der Bauteilträger mit seinem Basisbereich, seinem Verbindungsabschnitt und seiner einseitig daran angeformten Kopfplatte eine gemäß dem sogenannten Schrifttyp "Courier New" ("Schreibmaschinenlettern") 1-förmigen Querschnitt aufweist. Dadurch ist die Kopffläche zwar verkleinert doch zumindest eine Montagefläche des Verbindungsabschnitts ist vorteilhafterweise auch im eingebauten Zustand leicht zugänglich.

"Im Wesentlichen rechtwinklig" bedeutet, dass der Verbindungsabschnitt vom Basisbereich zur Kopffläche hin im Querschnitt auch leicht konisch zulaufen kann. Insbesondere kann dabei aber die Symmetrieebene zwischen seinen beiden einander gegenüberliegenden, konisch aufeinander zulaufenden Seitenflächen rechtwinklig zu der/den Auflagefläche(n) des Basisbereichs verlaufen. Die Winkel, den die Seitenflächen eines solchen, konisch zulaufenden Verbindungsabschnitts mit der/den Auflagefläche(n) des Basisbereichs bilden, können dabei also geringfügig größer oder gleich 90° sein. Geringfügig größer als 90° bedeutet dabei, dass die besagten Winkel zwischen 90° und 100°, bevorzugt zwischen 90° und 95°, besonders bevorzugt zwischen 90° und 94°, insbesondere zwischen 90° und 93°, also beispielsweise zwischen 90° und 92°, z.B. zwischen 90° und 91° liegen.

Ein Verfahren zur Bestückung der Leiterkarte mit den elektrischen Bauteilen besitzt folgende Schritte:
a.) Erstellen eines Leiterkartendesigns mit Leiterbahnen und mindestens einer standardisierten geometrischen Anordnung deren Kontaktanschlüsse, nämlich einem sogenannten "Footprint";
b.) Herstellung der Leiterkarte mit dem Leiterkartendesign;
c.) Auswahl oder Versehen mindestens eines Bauteilträgers mit Leiterbahnen, deren Leiterkartenanschlussbereiche ein dem Footprint der Leiterkarte entsprechendes geometrisches Muster bilden und welche andererseits bauteilanschlussseitig im Bereich einer zur Anbringung des mindestens einen elektrischen Bauteils vorgesehenen Position des Bauteilträgers enden;
d.) Anbringen des mindestens einen elektrischen Bauteils am Bauteilträger am Verbindungsabschnitt oder an der Kopffläche an seiner dafür vorgesehenen Position;
e.) Elektrisches Verbinden der elektrischen Anschlüsse des elektrischen Bauteils mit den Bauteilanschlussbereichen der Leiterbahnen,
f.) Bestücken der Leiterkarte mit dem mindestens einen Bauteilträger (1) durch Verlötung seiner Leiterkartenanschlussbereiche (20) mit den besagten Kontaktanschlüssen der Leiterkarte.

Dabei ist dem Fachmann selbstverständlich klar, dass die Verfahrensschritte c.) und d.) auch vor dem Verfahrensschritt b.) und insbesondere auch vor dem Verfahrensschritt a.) durchgeführt werden können.

Vorteilhafte Ausgestaltungen der Erfindung sind in den Unteransprüchen und der folgenden Beschreibung angegeben.

Die Erfindung ermöglicht eine erhebliche Vereinfachung der automatisierten Leiterkartenbestückung.

Ein besonderer Vorteil der Erfindung besteht insbesondere darin, dass durch den Bauteilträger eine Anordnung des mindestens einen elektrischen Bauteils im Wesentlichen senkrecht und/oder parallel zur Leiterkarte ermöglicht ist.

Durch die Erfindung kann weiterhin vorteilhaft vermieden werden, ein Leiterkartendesign ändern zu müssen, sobald ein bestimmtes Bauteil gegen ein anderes, z.B. ein funktionsgleiches oder funktionsähnliches, alternatives Bauteil eines anderen Herstellers ausgetauscht wird, weil sich die Anschlüsse des alternativen Bauteils an anderen Positionen befinden. Vorteilhafterweise kann es durch die Erfindung dabei weiterhin vermieden werden, den hohen Aufwand einer Verdrahtung mittels einzelner Litzen in Kauf zu nehmen. Es ist auch kein Ausweichen auf die Verwendung flexibler oder starr-flexibler Leiterkarten zum Anschluss des alternativen Bauteils notwendig.

Stattdessen gestaltet sich die Montage vergleichsweise sehr unaufwändig, indem die elektrischen Bauteile zunächst jeweils auf den dazugehörigen Bauteilträger montiert und bauteilseitig an dessen Leiterbahnen angeschlossen werden. In dieser Form können die Bauteile, auf dem Bauteilträger vormontiert gelagert oder sofort verwendet werden.

Der Bauteilträger wird dann sofort oder bei Bedarf seinerseits auf der Leiterkarte montiert und an deren bevorzugt standardisierten Footprint angeschlossen, z.B. verlötet. Die Verlötung der Leiterkartenanschlussbereiche des Bauteilträgers mit den besagten Kontaktanschlüssen der Leiterkarte kann dabei in der besagten SMT-Technik erfolgen, wobei aus den oben genannten Gründen keine Rücksicht auf eine mögliche Temperaturempfindlichkeit der Bauteile genommen zu werden braucht, welche am Verbindungsabschnitt und/oder gar an der Kopffläche des betreffenden Bauteilträgers angeordnet sind.

Selbstverständlich kann diese Reihenfolge der Montage auch umgekehrt - also erst der Bauteilträger auf der Leiterkarte und erst danach das Bauteil auf dem Bauteilträger montiert werden, was jedoch in den meisten Fällen nicht dem gewünschten Ablauf entspricht. Schließlich erschwert sich in den meisten Fällen die Montage dadurch, insbesondere wenn das elektrische Bauteil am Verbindungsabschnitt montiert wird.

Ein besonderer Vorteil der Erfindung besteht darin, dass der Bauteilträger im LDS-Verfahren auch in Kleinstserien an bestimmte elektrische Bauteile anpassbar ist. Schließlich können per Laseraktivierung die Leiterbahnen für an Position der Anschlüsse bestimmter Bauteile mit äußerst geringem Aufwand angepasst werden, ohne dass das Bauteil selbst davon in seiner Form betroffen ist.

Ein zusätzlicher Vorteil besteht darin, dass auf der Leiterkarte Bauraum eingespart wird.

Ein weiterer Vorteil der Erfindung besteht darin, dass der Bauteilträger, insbesondere bedingt durch seine Formgebung, die Wärmeübertragung zwischen dem mindestens einen darauf befestigten elektrischen Bauteil und der Leiterkarte stark reduziert. Dadurch wird zum einen die Temperaturentwicklung im Betriebszustand reduziert. Zum anderen wird aber auch eine automatisierte Bestückung, insbesondere in der "surface mounted technologie" (SMT) - Verlötung, auch für temperaturempfindliche elektrische Bauteile ermöglicht. Insbesondere kann dabei im Produktionsprozess auch die Reihenfolge der Montage optimal an die prozesstechnischen Notwendigkeiten angepasst werden, d.h. das entsprechende Bauteil kann beispielsweise zunächst auf dem Bauteilträger angebracht und mit seinen individuellen Anschlüssen problemlos mit den individuell dafür auf dem Bauteilträger aufgebrachten Leiterbahnen elektrisch leitend verbunden werden. Daraufhin kann der Bauteilträger problemlos mittels der besagten SMT unabhängig von der Temperaturempfindlichkeit seines Bauteils auf der Leiterkarte verlötet werden.

In einer bevorzugten Ausgestaltung kann der Bauteilträger an den bauteilseitigen Enden seiner Leiterbahnen Bauteilanschlussbereiche ("Kontaktpads") aufweisen, die sich in der Nähe der jeweiligen Anschlüsse des elektrischen Bauteils befinden. Diese können zusammen mit den Leiterbahnen in einem MID-Verfahren, bevorzugt im LDS-Verfahren, auf den Bauteilträger aufgebracht werden. Die Leiterkartenanschlussbereiche der Auflageflächen können sich in zueinander festgelegten Relativpositionen befinden, welche mit dem/den besagten, insbesondere standardisierten, Footprint(s) der Leiterkarte korrespondieren.

In einer bevorzugten Ausgestaltung kann die Kopfplatte über die gesamte Breite des Verbindungsabschnitts an dessen, dem Basisbereich abgewandten Ende angeformt sein und somit die gleiche Breite aufweisen wie der Verbindungsabschnitt. Dadurch ist die Kopffläche ausreichend groß und somit für viele Anwendungen auch als weitere Montagefläche für etwas größere elektrische Bauteile geeignet.

In einer anderen Ausgestaltung ist die Kopfplatte schmaler als der Verbindungsabschnitt. Dann ist sie in der Regel als Ansaugfläche vorgesehen, kann auch für relativ kleine elektrische Bauteile genutzt werden. Diese Variante hat den Vorteil einer gewissen Materialersparnis, welche beispielsweise bei Verwendung von LDS-Material eine durchaus wichtige Rolle spielt. Außerdem kann dann die darunterliegende Montagefläche an den Bauteilanschlussbereichen zugänglich sein. Insbesondere kann die Kopfplatte in dieser Bauform mittig an das Ende des Verbindungsabschnitts angeformt sein, so dass der Verbindungsabschnitt an seinem dem Basisbereich abgewandten Ende beidseitig der Kopfplatte jeweils einen frei stehenden Kantenabschnitt, und somit insgesamt zwei freistehende Kantenabschnitte, besitzt, welche durch die Kopfplatte voneinander getrennt sind.

In einer weiteren Ausgestaltung kann der Verbindungsabschnitt genau eine Montagefläche besitzen. An seiner der Montagefläche gegenüberliegende Fläche kann dann zur Verstärkung ein Steg als Verstärkungselement angeformt sein.

An den Verbindungsabschnitt eines anderen Bauteilträgers kann an seiner der Montagefläche gegenüberliegende Fläche zur Verstärkung ein massiver Zylinder oder ein massiver Halbkegel als Verstärkungselement angeformt sein. Dessen von der Basis abgewandte Fläche kann die Kopffläche bilden. Handelt es sich bei dem Verstärkungselement um den besagten Halbkegel, so kann dieser weiterhin vom Basisbereich zur Kopffläche hin konisch zulaufend ausgestaltet sein.

Bei dem Bauteilträger mit dem als Halbzylinder oder Halbkegel ausgeführten Verstärkungselement kann der damit verstärkte Verbindungsabschnitt, also der Verbindungsabschnitt zusammen mit dem jeweiligen Verstärkungselement, mit Blick auf die Kopffläche 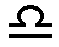 - förmig ausgeführt sein.

All diese Bauteilträger, die ein Verstärkungselement aufweisen, besitzen dadurch den Vorteil einer erhöhten Stabilität, verlieren aber Bauraum für elektrische Bauteile.

Um letzterem zu begegnen, kann der Bauteilträger zusätzlich und insbesondere parallel zum besagten Verbindungsabschnitt einen weiteren, insbesondere formgleichen Verbindungsabschnitt aufweisen. Der Verbindungsabschnitt und der weitere Verbindungsabschnitt können miteinander über einen Verbindungsbereich verbunden sein, der seinerseits eine dem Basisbereich abgewandte Fläche besitzt, welche die Kopffläche bildet. Der Verbindungsbereich kann mittig zwischen den beiden Verbindungsabschnitten angeordnet sein, so dass die beiden Verbindungsbereiche zusammen mit dem Verbindungsabschnitt in der Draufsicht eine H-Form bilden. Dadurch bleiben die beiden großen Montageflächen des Verbindungsabschnitts zur möglichen Montage der elektrischen Bauteile erhalten. Auch wird durch diese Anordnung ein hohes Maß an Stabilität gewährleistet. Weiterhin kann durch diese Bauform der Schwerpunkt, der sich durch das Anbringen des elektrische Bauteils verschiebt, wieder zentriert werden.

### Ausführungsbeispiel

Ein Ausführungsbeispiel der Erfindung ist in den Zeichnungen dargestellt und wird im Folgenden näher erläutert. Es zeigen:
- Fig. 1a-f: einen Bauteilträger in einer ersten Ausführung;
- Fig. 2a-e: den Bauteilträger in verschiedenen Anwendungen;
- Fig. 3a-b: den Bauteilträger in einer zweiten Ausführung;
- Fig. 4a-b: den Bauteilträger in einer dritten Ausführung;
- Fig. 5a-b: den Bauteilträger in einer vierten Ausführung;
- Fig. 6a-c: einen weiteren Bauteilträger, der nicht in den Umfang der Ansprüche fällt;
- Fig. 7a-b: einen weiteren Bauteilträger, der nicht in den Umfang der Ansprüche fällt.

Die Figuren enthalten teilweise vereinfachte, schematische Darstellungen. Zum Teil werden für gleiche, aber gegebenenfalls nicht identische Elemente identische Bezugszeichen verwendet. Verschiedene Ansichten gleicher Elemente könnten unterschiedlich skaliert sein.

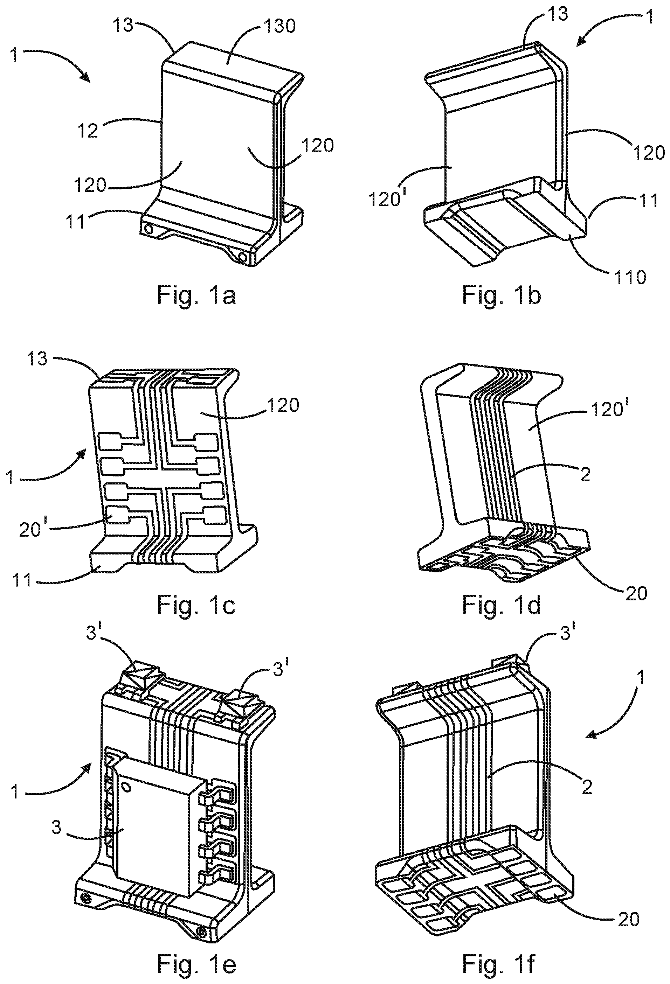

Die Fig. 1a -1f zeigt einen Bauteilträger 1 in einer ersten Ausführung mit seinem Basisbereich 11, Verbindungsabschnitt 12 und einer Kopfplatte 13, welche an den Verbindungsabschnitt 12 angeformt ist und von ihm fort weist. Dieser Bauteilträger besitzt gemäß dem sogenannten Schrifttyp "Courier New" ("Schreibmaschinenlettern") l-förmigen Querschnitt. An seiner vom Basisbereich 11 abgewandten Seite besitzt die Kopfplatte 13 eine Kopffläche 130, die bei einer automatisierten Leiterkartenbestückung als Ansaugfläche verwendet werden kann. In der Fig. 1b sind unten zwei Auflageflächen 110 des Basisbereichs 11 dargestellt. Diese dienen der Kontaktierung einer nicht in der Zeichnung gezeigten Leiterkarte.

In der Fig. 1c und 1d ist der Bauteilträger gezeigt, nachdem er im LDS ("laser direct structuring") - Verfahren mit Leiterbahnen 2 versehen wurde. Die Fig. 1c ermöglicht einen Blick auf die Montagefläche 120 des Verbindungsabschnitts 12 sowie auf die Kopffläche 130 der Kopfplatte 13. Die Fig. 1c ermöglicht einen Blick auf die Kopffläche 130 sowie auf die Montagefläche 120 mit den Bauteilanschlussbereichen 20'. In der Fig. 1d sind die Auflageflächen 110 zu sehen. Dort befinden sich die leiterkartenanschlussseitigen Enden der Leiterbahnen 2 mit ihren Leiterkartenanschlussbereichen 20.

Die Fig. 1e und 1f zeigen den mit elektrischen Bauteilen 3, 3' bestückten Bauteilträger 1, der mit entsprechenden Leiterbahnen 2 versehen ist.

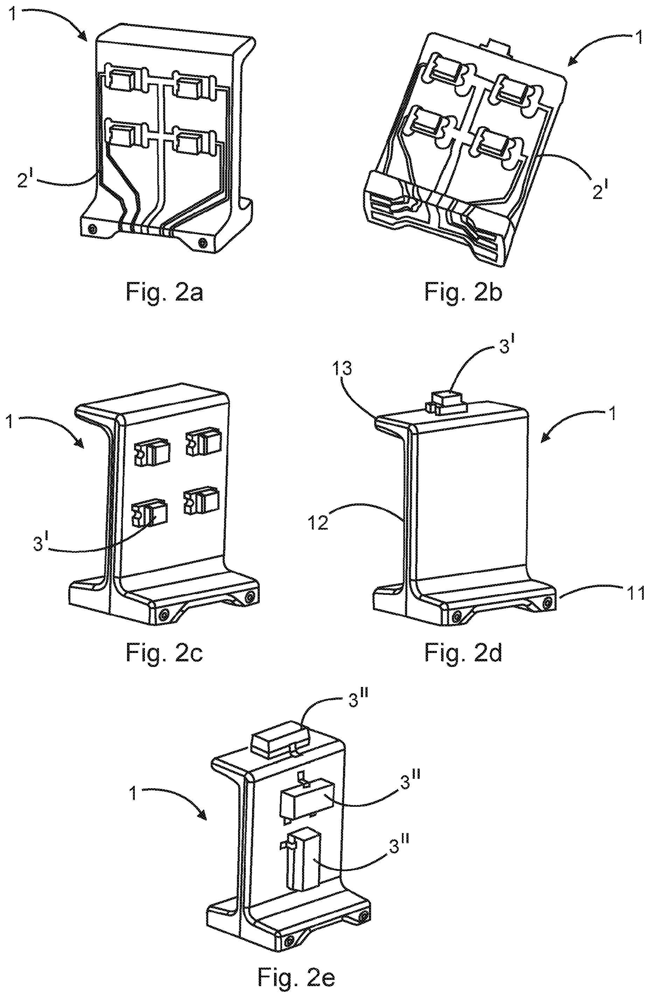

Die Fig. 2a und 2b zeigen den Bauteilträger mit individuell gestalteten Leiterbahnen 2'. Diese Leiterbahnen 2 können beispielsweise von einem Kunden oder im Kundenauftrag im LDS-Verfahren auf den Bauteilträger 1 aufgebracht werden, um den gewünschten Einsatz bestimmter elektrischer Bauteile 3', und zwar auch in einer gewünschten geometrischen Anordnung, zu ermöglichen.

Die Fig. 2c zeigt eine dazugehörige Anwendung, bei der vier verschiedenfarbige Leuchtdioden 3' auf der Montagefläche angeordnet sind. In der Fig. 2b dient der Bauteilträger 1 als Abstandshalter für eine Leuchtdiode 3'. In der Fig. 2e sind drei gleiche Beschleunigungssensoren 6 am Bauteilträger 1 in unterschiedlichen Orientierungen angeordnet, um die Beschleunigung in drei Richtungen aufnehmen zu können.

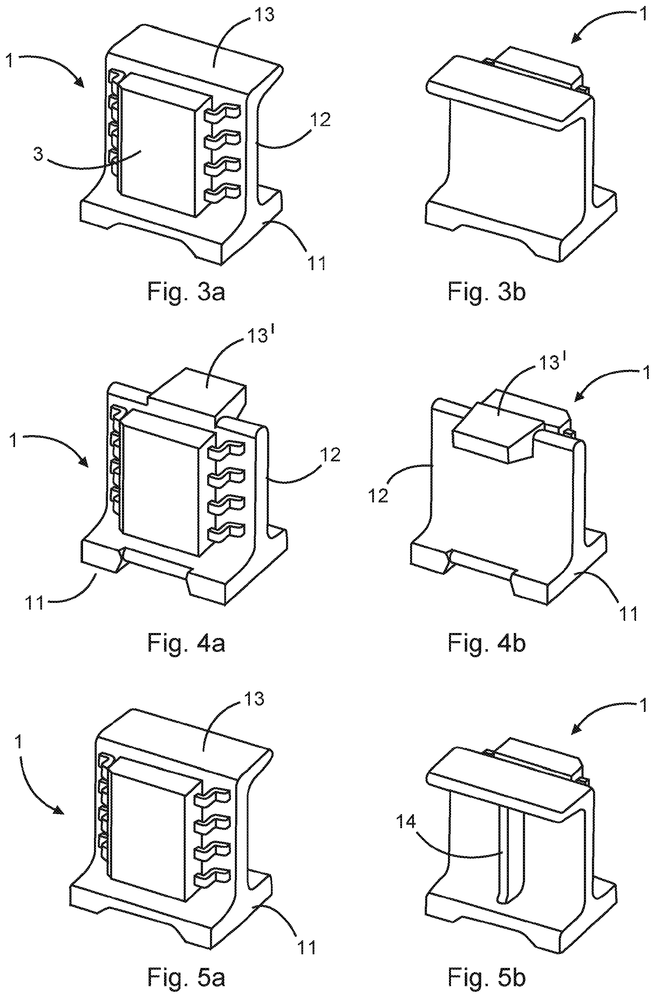

In der Fig. 3a und 3b ist der Bauteilträger 1 in einer zweiten Ausführung gezeigt. Dabei ist der Verbindungsabschnitt 12 zur geometrischen Anpassung an das elektrische Bauteil 3 etwas kürzer als in der ersten Ausführung. Somit ist der Bauraum auf der Seitenfläche 12 etwas geringer, d.h. für etwas kleinere Bauteile 3 geeignet, und die Gesamtanordnung nimmt weniger Platz in Anspruch.

In den Fig. 4a und 4b ist der Bauteilträger 1 in einer dritten Ausführung gezeigt. Dabei ist die Kopfplatte 13' kürzer als in der zweiten Ausführung. Sie kann dennoch als Ansaugfläche und weiterhin auch als weitere Montagefläche für sehr kleine elektrische Bauteile 3 , 3" dienen, z.B. für eine der vorgenannten Leuchtdioden 3'. Sie weist von dem Verbindungsabschnitt 12 und seiner Montagefläche weg.

Die Fig. 5a und 5b zeigen den Bauteilträger 1 in einer vierten Ausführung. Diese ist vergleichbar mit der zweiten Ausführung, besitzt jedoch einen zusätzlichen Steg 14 als Verstärkungselement.

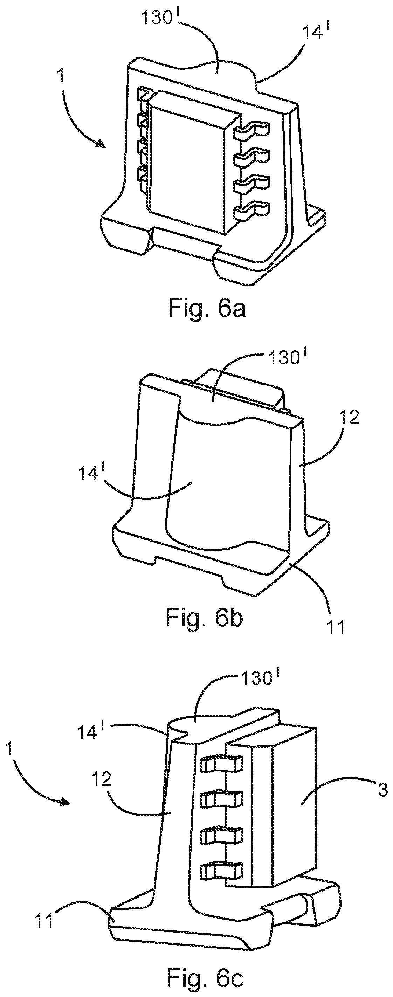

In den Fig. 6a, 6b und 6c ist ein weiterer Bauteilträger 1gezeigt, der als Verstärkungselement einen vom Basisbereich 11 in Richtung der Kopffläche 130' verlaufenden massiven Halbkegel 14', der vom Basisbereich 11 zur Kopffläche 130' konisch zuläuft. Die besagte Kopffläche 130' ist durch die vom Basisbereich 11 abgewandte Fläche des Halbkegels 14' gebildet.

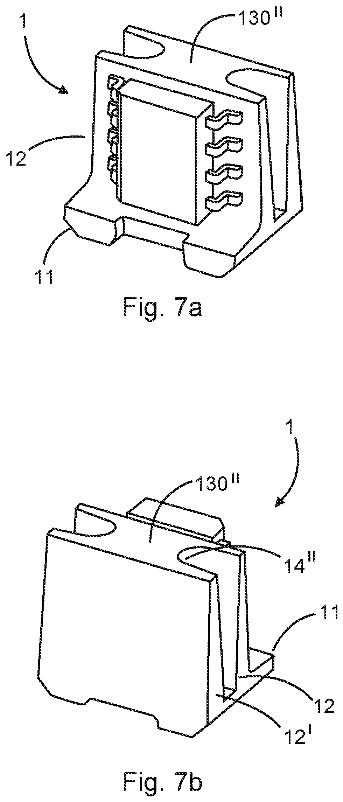

Die Fig. 7a und 7b zeigen einen weiteren Bauteilträger 1, der einen weiteren Verbindungsabschnitt 12' besitzt. Der Verbindungsabschnitt 12 und der weitere Verbindungsabschnitt 12' sind miteinander über einen massiven Verbindungsbereich 14" als Verstärkungselement verbunden, dessen dem Basisbereich 11 abgewandte Seite die Kopffläche 130" bildet.

Der Verbindungsbereich 14" ist dabei mittig zwischen den beiden Verbindungsabschnitten 12,12' angeordnet, so dass die beiden Verbindungsbereiche 12,12' zusammen mit dem Verbindungsabschnitt 14" in der Draufsicht eine H-Form bilden.

Durch diese Anordnung kann der Schwerpunkt des Bauteilträgers 1, der sich durch das Anbringen des elektrische Bauteils 3 verschiebt, insgesamt wieder zentriert werden.

### Bezugszeichenliste

1 Bauteilträger
11 Basisbereich
110 Auflagefläche(n)
12,12' Verbindungsabschnitt
120,120' Seitenfläche(n) / Montagefläche(n)
13,13' Kopfplatte
130,130', 130" Kopffläche
14,14',14" Verstärkungselemente (Steg / Halbkegel / Verbindungsbereich)
2,2' Leiterbahnen
20 Leiterkartenanschlussbereiche / Leiterkartenanschlusspads
20' Bauteilanschlussbereiche / Bauteilanschlusspads
3 elektrisches Bauteil, Mikroprozessor
3' Leucht-LEDs, Leuchtdiode
3" Beschleunigungssensoren

## Patentansprüche

1. Bauteilträger (1), bestehend aus einem elektrisch isolierenden Material, aufweisend einen Basisbereich (11) mit einer oder mehreren Auflageflächen (110) zur elektrischen und mechanischen Verbindung mit einer Leiterkarte, sowie zumindest einen im Wesentlichen rechtwinklig zum Basisbereich (11) verlaufenden, im Wesentlichen flächigen Verbindungsabschnitt (12, 12'), der zumindest eine ebene Seitenfläche (120,120') als Montagefläche besitzt, auf der ein- oder mehrere elektrische Bauteile (3,3',3") montiert werden können, und der weiterhin eine Kopffläche (130, 130', 130") besitzt, welche an einem vom Basisbereich (11) abgewandten Ende des Verbindungsabschnitts (12, 12') angeordnet und parallel zum Basisbereich (11) ausgerichtet ist, und die sowohl als Ansaugfläche zur automatisierten Leiterkartenbestückung dient, als auch als weitere Montagefläche zur Montage eines oder mehrerer weiterer elektrischer Bauteile (3, 3',3") nutzbar ist,
wobei der Bauteilträger (1) mit mehreren Leiterbahnen (2, 2') versehen ist, welche leiterkartenanschlussseitig an zumindest eine der Auflageflächen (110) des Basisbereichs (11) geführt sind und dort zur Verlötung mit der Leiterkarte mit ihren jeweiligen Leiterkartenanschlussbereichen (20) enden und an ihrem jeweils anderen Ende zur jeweiligen Montageposition zumindest eines der elektrischen Bauteile (3, 3', 3") geführt sind und jeweils in der Nähe der elektrischen Anschlüsse des dort zu montierenden elektrischen Bauteils (3, 3', 3") mit ihren Bauteilanschlussbereichen (20') enden, wobei
der Verbindungsabschnitt (12) beidseitig flächig ausgeführt ist und somit zwei einander gegenüberliegende Montageflächen (120,120') besitzt, und wobei an den Verbindungsabschnitt (12) an einem dem Basisbereich (11) abgewandten Ende parallel zum Basisbereich (11) eine Kopfplatte (13, 13') angeformt ist, welche an ihrer dem Basisbereich (11) abgewandten Seite die Kopffläche (130) aufweist,
**dadurch gekennzeichnet, dass**
die Kopfplatte (13, 13') an den Verbindungsabschnitt (12) nur einseitig, also in Richtung einer ihrer beiden einander gegenüberliegenden Montageflächen (120,120'), von dem Verbindungsabschnitt (12) fortweist, so dass der Bauteilträger mit seinem Basisbereich (11), seinem Verbindungsabschnitt (12) und seiner einseitig daran angeformten Kopfplatte (13, 13') eine gemäß dem sogenannten Schrifttyp "Courier New", "Schreibmaschinenlettern", 1-förmigen Querschnitt aufweist.

2. Bauteilträger (1) gemäß Anspruch 1, wobei der Bauteilträger (1) aus Kunststoff besteht.

3. Bauteilträger (1) nach einem der vorstehenden Ansprüche, wobei der Bauteilträger (1) in einem "MID"**,** moulded interconnect device, Verfahren hergestellt ist.

4. Bauteilträger (1) nach einem der vorstehenden Ansprüche, wobei der Bauteilträger mit seinen Leiterbahnen (2, 2') im sogenannten "LDS", Laser Direct Structuring, - Verfahren gefertigt ist.

5. Bauteilträger (1) nach einem der Ansprüche 1 bis 4, wobei die Kopffläche (130) über die gesamte Breite des Verbindungsabschnitts (12) an dessen dem Basisbereich (11) abgewandten Ende angeformt ist, also die gleiche Breite aufweist wie der Verbindungsabschnitt (12).

6. Bauteilträger (1) nach einem der der Ansprüche 1 bis 4, wobei die Kopfplatte (13') schmaler ist als der Verbindungsabschnitt (12).

7. Bauteilträger (1) nach Anspruch 6, wobei die Kopfplatte (13') mittig an das Ende des Verbindungsabschnitts (12) angeformt ist, so dass der Verbindungsabschnitt (12) an seinem dem Basisbereich (11) abgewandten Ende beidseitig der Kopfplatte (13') jeweils einen frei stehenden Kantenabschnitt, und somit insgesamt zwei freistehende Kantenabschnitte, besitzt.

8. Bauteilträger (1) nach einem der Ansprüche 1 bis 7, wobei der Verbindungsabschnitt (12) genau eine Montagefläche (120) besitzt, und wobei an den Verbindungsabschnitt (12) an seiner der Montagefläche (120) gegenüberliegende Fläche als Verstärkungselement ein Steg (14) angeformt ist.

9. Verfahren zur Bestückung einer Leiterkarte mit elektrischen Bauteilen (3,3',3") mittels mindestens eines Bauteilträgers (1) nach einem der Ansprüche 1 bis 8, umfassend folgende Schritte:
a.) Erstellen eines Leiterkartendesigns mit Leiterbahnen und mindestens einer standardisierten geometrischen Anordnung deren Kontaktanschlüsse, nämlich einem sogenannten "Footprint";
b.) Herstellung der Leiterkarte mit dem Leiterkartendesign;
c.) Auswahl oder Versehen des mindestens einen Bauteilträgers (1) mit Leiterbahnen (2, 2'),
- deren Leiterkartenanschlussbereiche (20) an seiner mindestens einen Auflagefläche (110) ein dem Footprint der Leiterkarte entsprechendes geometrisches Muster bilden, und die
- andererseits bauteilanschlussseitig im Bereich einer zur Anbringung des mindestens einen elektrischen Bauteils (3,3',3") vorgesehenen Position des Bauteilträgers (1) enden;
d.) Anbringen des mindestens einen elektrischen Bauteils (3,3',3") an einer Montagefläche (120,120') oder Kopffläche (130,130') des Bauteilträgers (1);
e.) elektrisches Verbinden der elektrischen Anschlüsse des elektrischen Bauteils (3,3',3") mit den Bauteilanschlussbereichen (20') der Leiterbahnen (2);
f.) Bestücken der Leiterkarte mit dem mindestens einen Bauteilträger (1) durch Verlötung seiner Leiterkartenanschlussbereiche (20) mit den besagten Kontaktanschlüssen der Leiterkarte.

10. Verfahren gemäß Anspruch 9, wobei in Verfahrensschritt f.) die Leiterbahnen (2) mittels einem LDS-Verfahren auf den Bauteilträger (1) aufgebracht werden.

11. Verfahren gemäß Anspruch 9 oder 10, wobei Verfahrensschritt f.) in einem sogenannten SMT, "surface mounted technology", - Verfahren erfolgt.

## Claims

1. Component carrier (1) consisting of an electrically insulating material, comprising a base region (11) with one or more supporting surfaces (110) for electrical and mechanical connection to a circuit board, and at least one substantially flat connecting section (12, 12') which extends substantially at a right angle to the base region (11) and has at least one flat side surface (120, 120') as a mounting surface, on which one or more electrical components (3, 3', 3") can be mounted, and which furthermore has a top surface (130, 130', 130") which is arranged on an end of the connecting section (12, 12') facing away from the base region (11) and is oriented parallel to the base region (11), and which is used both as a suction surface for automated circuit board population and can also be used as a further mounting surface for mounting one or more further electrical components (3, 3', 3"),
wherein the component carrier (1) is provided with a plurality of conductor tracks (2, 2') which are guided on the circuit board connection side on at least one of the supporting surfaces (110) of the base region (11) and end there for soldering to the circuit board with their respective circuit board connection regions (20) and at their respective other end to the respective assembly position of at least one of the electrical components (3, 3', 3") and end in each case in the vicinity of the electrical connections of the electrical component (3, 3', 3") to be mounted there with their component connection regions (20'), wherein
the connecting section (12) is flat on both sides and thus has two mounting surfaces (120, 120') lying opposite one another, and wherein a head plate (13, 13') is formed on the connecting section (12) on an end facing away from the base region (11) parallel to the base region (11), which head plate has the top surface (130) on its side facing away from the base region (11),
**characterized in that**
the head plate (13, 13') points from the connecting section (12) to the connecting section (12) only on one side, that is to say in the direction of one of its two mounting surfaces (120, 120') lying opposite one another, so that the component carrier with its base region (11), its connecting section (12) and its head plate (13, 13') formed on one side thereon has an 1-shaped cross-section in accordance with the so-called font type "Courier New", "Typewriter ".

2. Component carrier (1) according to claim 1, wherein the component carrier (1) consists of plastic.

3. Component carrier (1) according to one of the preceding claims, wherein the component carrier (1) is produced using an "MID", molded interconnect device, method.

4. Component carrier (1) according to one of the preceding claims, wherein the component carrier with its conductor tracks (2, 2') is produced using the so-called "LDS", Laser Direct Structuring, method.

5. Component carrier (1) according to one of claims 1 to 4, wherein the top surface (130) is formed over the entire width of the connecting section (12) at the end thereof facing away from the base region (11), i.e. the top surface (130) has the same width as the connecting section (12).

6. Component carrier (1) according to one of claims 1 to 4, wherein the head plate (13') is narrower than the connecting section (12).

7. Component carrier (1) according to claim 6, wherein the head plate (13 ') is formed centrally on the end of the connecting section (12), so that the connecting section (12) has, at its end facing away from the base region (11), on both sides of the head plate (13 ') in each case a free-standing edge section, and thus has a total of two free-standing edge sections.

8. Component carrier (1) according to one of claims 1 to 7, wherein the connecting section (12) has precisely one mounting surface (120), and wherein a web (14) is integrally formed as a reinforcing element on the surface of the connecting section (12) which is opposite the mounting surface (120).

9. Method for populating a circuit board with electrical components (3, 3', 3") by means of at least one component carrier (1) according to one of claims 1 to 8, comprising the following steps:
a.) creating a circuit board design having conductor tracks and at least one standardized geometrical arrangement of the contact connections thereof, namely a so-called "footprint";
b.) producing the circuit board with the circuit board design;
c.) selecting or providing the at least one component carrier (1) with conductor tracks (2, 2'),
- the circuit board connection regions (20) of which form a geometric pattern corresponding to the footprint of the circuit board on the at least one supporting surface (110) thereof, and which
- on the other hand, on the component connection side, end in the region of a position of the component carrier (1) provided for mounting the at least one electrical component (3, 3', 3");
d.) mounting the at least one electrical component (3, 3', 3") on a mounting surface (120, 120') or top surface (130, 130') of the component carrier (1);
e.) electrically connecting the electrical connections of the electrical component (3, 3', 3") to the component connection regions (20') of the conductor tracks (2);
f.) populating the circuit board with the at least one component carrier (1) by soldering its circuit board connection regions (20) to said contact connections of the circuit board.

10. Method according to claim 9, wherein in method step f.) the conductor tracks (2) are applied to the component carrier (1) by means of an LDS-method.

11. Method according to claim 9 or 10, wherein method step f.) is carried out using a so-called SMT, "surface mounted technology" - method.

## Revendications

1. Support de composants (1), constitué d'un matériau électriquement isolant, comprenant une zone de base (11) dotée d'une ou plusieurs surfaces de contact (110) pour la connexion électrique et mécanique à une carte de circuit imprimé, et au moins une section de connexion sensiblement plane (12, 12') s'étendant sensiblement perpendiculairement à la zone de base (11), présentant au moins une surface latérale plane (120, 120') comme surface de montage pour un ou plusieurs composants électriques (3, 3', 3"), et comprenant en outre une surface de tête (130, 130', 130") disposée à une extrémité de la section de connexion (12, 12') opposée à la zone de base (11) et alignée parallèlement à celle-ci, servant à la fois de surface d'aspiration pour l'assemblage automatisé de la carte de circuit imprimé et de surface de montage supplémentaire pour un ou plusieurs composants électriques additionnels. (3, 3', 3") est utilisable,
le support de composants (1) étant doté de plusieurs pistes conductrices (2, 2') qui, côté connexion au circuit imprimé, sont reliées à au moins une des surfaces de support (110) de la zone de base (11) et s'y terminent pour être soudées au circuit imprimé via leurs zones de connexion respectives (20), et, à leurs autres extrémités, ces pistes sont reliées à la position de montage respective d'au moins un des composants électriques (3, 3', 3") et se terminent près des connexions électriques du composant (3, 3', 3") à y monter via ses zones de connexion (20'),
la section de connexion (12) étant conçue comme une surface plane sur ses deux faces et présentant ainsi deux surfaces de montage opposées (120, 120') ; une plaque de tête (13, 13') étant fixée à la section de connexion (12) à une extrémité parallèle à la zone de base (11) et opposée à la zone de base (11) ; cette plaque de tête (13, 13') est constitué de la surface de tête (130) disposée sur sa face opposée à la zone de base (11),
**caractérisé en ce que** cette plaque de tête (13, 13') s'étend de la section de connexion (12) d'un seul côté, c'est-à-dire dans la direction de l'une de ses deux surfaces de montage opposées (120, 120') ;ainsi, le support de composant, avec sa zone de base (11), sa section de connexion (12) et sa plaque de tête (13, 13') disposées sur une seule face, présente une section transversale en forme de l, semblable à celle des caractères dits « Courier New », « lettres de machine à écrire».

2. Support de composant (1) selon la revendication 1, **caractérisé en ce que** le support de composant (1) est réalisé en matière plastique.

3. Support de composant (1) selon l'une des revendications précédentes, **caractérisé en ce que** le support de composant (1) est fabriqué par un procédé dit MID, « dispositif d'interconnexion moulé ».

4. Support de composant (1) selon l'une des revendications précédentes, dans lequel le support de composant et ses pistes conductrices (2, 2') sont fabriqués par le procédé dit « LDS », Laser Direct Structuring.

5. Support de composant (1) selon l'une des revendications 1 à 4, dans lequel la surface de tête (130) est formée sur toute la largeur de la section de connexion (12) à son extrémité opposée à la zone de base (11), c'est-à-dire que la surface de tête (130) a la même largeur que la section de connexion (12).

6. Support de composant (1) selon l'une des revendications 1 à 4, dans lequel la plaque de tête (13') est plus étroite que la section de connexion (12).

7. Support de composant (1) selon la revendication 6, dans lequel la plaque de tête (13') est formée au centre de l'extrémité de la section de connexion (12), de sorte que la section de connexion (12) présente un bord libre de chaque côté de la plaque de tête (13') à son extrémité opposée à la zone de base (11), soit un total de deux bords libres.

8. Support de composant (1) selon l'une des revendications 1 à 7, dans lequel la section de connexion (12) présente exactement une surface de montage (120), et dans lequel une nervure (14) est formée sur la section de connexion (12) à sa surface opposée à la surface de montage (120) en tant qu'élément de renforcement.

9. Procédé d'intégration de composants électriques (3, 3', 3") sur une carte de circuit imprimé à l'aide d'au moins un support de composant (1) selon l'une des revendications 1 à 8, comprenant les étapes suivantes :
a) Création d'un schéma de carte de circuit imprimé comportant des pistes conductrices et au moins une disposition géométrique normalisée de leurs connexions de contact, appelée « empreinte » ;
b) fabrication de la carte de circuit imprimé selon ce schéma ;
c) sélection ou dotation d'au moins un support de composant (1) de pistes conductrices (2, 2'),
- dont les zones de connexion (20) forment un motif géométrique correspondant à l'empreinte de la carte de circuit imprimé sur au moins une de ses surfaces de contact (110), et qui
- se terminent, côté connexion du composant, dans une zone du support de composant (1) prévue pour la fixation du ou des composants électriques (3, 3', 3").
d) montage d'au moins un composant électrique (3, 3', 3") sur une surface de montage (120, 120') ou une surface de tête (130, 130') du support de composants (1) ;
e) connexion électrique des bornes électriques du composant (3, 3', 3") aux zones de connexion (20') des pistes conductrices (2) ;
f) placement d'au moins un support de composant (1) sur la carte de circuit imprimé par soudage de ses zones de connexion (20) aux contacts de la carte.

10. Procédé selon la revendication 9, dans lequel, à l'étape f.), les pistes conductrices (2) sont appliquées sur le support de composant (1) par un procédé LDS.

11. Procédé selon la revendication 9 ou 10, dans lequel l'étape f.) est réalisée par un procédé dit SMT, « technologie de montage en surface ».
